# EUROPEAN PATENT SPECIFICATION

(11) **EP 2 647 036 B1**
(45) Date of publication and mention of the grant of the patent: **11.10.2017**
(21) Application number: 11844695.4
(22) Date of filing: 26.11.2011
(51) Int. Cl.: H01L 21/265, H01J 37/30, H01J 37/317, H01J 37/08, C23C 14/48

(54) **Remote dopant source for an ion implanter system, ion implanter system and method comprising same**
Entfernte Dotiergasquelle für eine Ionenimplantierungsvorrichtung, Ionenimplantierungsvorrichtung und Verfahren damit
Source de dopant distante pour système d'implantation d'ions, système et procédé d'implantation d'ions comprenant ladite source

(30) Priority: 30.11.2010 US 418402 P
(43) Date of publication of application: 09.10.2013
(73) Proprietor: ENTEGRIS INC., Billerica, MA 01821 (US)
(72) Inventor: OLANDER, W., Karl, Indian Shores FL 33785 (US); KAIM, Robert, Brookline MA 02446 (US); SWEENEY, Joseph, D., Winsted CT 06098 (US); DESPRES, Joseph, R., Middletown CT 06457 (US)
(74) Representative: ABG Patentes, S.L.
(86) International application number: PCT/US2011/062168
(87) International publication number: WO 2012/074889

(56) References cited:
- JP-A- S6 298 543
- JP-A- 2004 039 475
- JP-A- 2007 324 095
- US-A- 5 160 825
- US-A- 5 935 305
- US-A1- 2003 068 851
- US-A1- 2003 234 165
- US-A1- 2007 210 260
- US-A1- 2008 220 596
- US-A1- 2008 289 576
- US-A1- 2010 187 448
- US-B1- 6 515 290

## Description

### FIELD

The present disclosure relates to apparatus and method for supplying dopant source gas to an ion implanter for use in the doping of materials, such as semiconductor substrates, flat panel display substrates, solar panel substrates, etc., and to ion implantation systems utilizing such apparatus and method.

### DESCRIPTION OF THE RELATED ART

Ion implantation is a basic unit operation in the manufacture of microelectronic device products. Consistent with the fundamental character and ubiquity of ion implantation operations in semiconductor manufacturing facilities, substantial efforts have been and continue to be made to improve the efficiency and effectiveness of ion implanter equipment.

Since almost all conventional dopant feedstock gases used in ion implantation are of a highly toxic and hazardous character, the foregoing efforts have included a focus on the objective of enhancing safety in the supply, handling and use of dopant source materials.

During the last 15 years the commercialization and widespread deployment in ion implantation systems of physical adsorbent-based fluid storage and dispensing vessels of a type available from ATMI, Inc. (Danbury, CT, USA) under the trademark SDS have made a major contribution to such safety enhancement efforts. By providing a physical adsorbent medium in the fluid storage and dispensing vessel as a storage medium for toxic and hazardous dopant source fluids such as arsine, phosphine, silane and boron trifluoride, such fluids can be sorptively retained in the vessel at low, e.g., sub-atmospheric, pressures and readily desorbed from the physical adsorbent under dispensing conditions.

Such low pressure storage and dispensing vessels thus overcome the dangers incident to the use of high pressure gas cylinders holding the same dopant source fluids at high super-atmospheric pressures on the order of 3,000 to 15,000 kPa. These dangers include the potential for catastrophic dispersion of highly pressurized toxic/hazardous fluids in the event of a rupture of the cylinder body or failure of a valve head assembly of the high pressure gas cylinder.

The ion implantation system is characteristically configured with a gas box, an ion source unit for ionization of the dopant feedstock gas, an implanter including accelerator and magnetic separation components, and associated flow circuitry and instrumentation. In the ion implantation system, the dopant gas supply vessels are located in the gas box of the system. The gas box is an enclosure connected to and at the same high voltage as the ion source unit in operation.

In this conventional ion implantation system configuration, the supply vessels containing the toxic/hazardous dopant feedstock gas have to be periodically changed out and replaced by fresh vessels charged with the dopant source gas. To carry out such change-out of gas supply vessels located inside the ion implantation system gas box, technicians must don self-contained breathing apparatus (SCBA) units, physically remove exhausted supply vessels from the gas box and install fresh vessels in the gas box. In conducting the change-out operation, the vicinity of the ion implantation system in the semiconductor manufacturing facility must be cleared of personnel other than the SCBA-equipped technicians, in order to accommodate the risks involved with the change-out operation.

In addition to the dangers associated with such change-out of dopant source gas supply vessels in the ion implantation system, it is also a common occurrence that dopant source gas supply vessels become exhausted at inconvenient times during production operations, so that the ion implantation system must be shut down. Such unscheduled shutdown of the ion implantation system can require expensive reworking of partially processed wafers, and in some cases the wafer products may be deficient or even useless for their intended purpose, as a consequence of the interruption of their processing. Such events can in turn seriously adversely affect the ion implanter system and the economics of the semiconductor manufacturing facility in which such ion implanter system is located.

US 5 160 825 A discloses an ion implantation system with a dopant source gas supply apparatus; comprising a dopant source gas local vessel C1, C2 that in operation is a high voltage 2 relative to ground and positioned (together with ion implantation tool 1) in an earthed outer enclosure 3. A dopant source gas supply vessel 10, 11 is positioned remote from the ion implantation system, outside the outer enclosure 3. A supply line 14, 14' interconnects the dopant source gas supply vessel 10, 11 in supply relationship to said dopant source gas local vessel C1, C2, and is adapted to flow dopant source gas from the supply vessel 10, 11 to the local vessel C1, C2 only when the ion implantation tool is in a non-operational state and the local vessel C1, C2 is not at high voltage.

### SUMMARY

The present invention relates to a dopant source gas supply apparatus according to claim 1, an ion implantation system according to claim 7 including such a dopant source gas supply apparatus, and an ion implantation method according to claim 9 comprising the use of such a dopant source gas supply apparatus. Preferred aspects are set out in the dependent claims.

Other aspects, features and embodiments of the disclosure will be more fully apparent from the ensuing description.

### BRIEF DESCRIPTION OF THE DRAWINGS

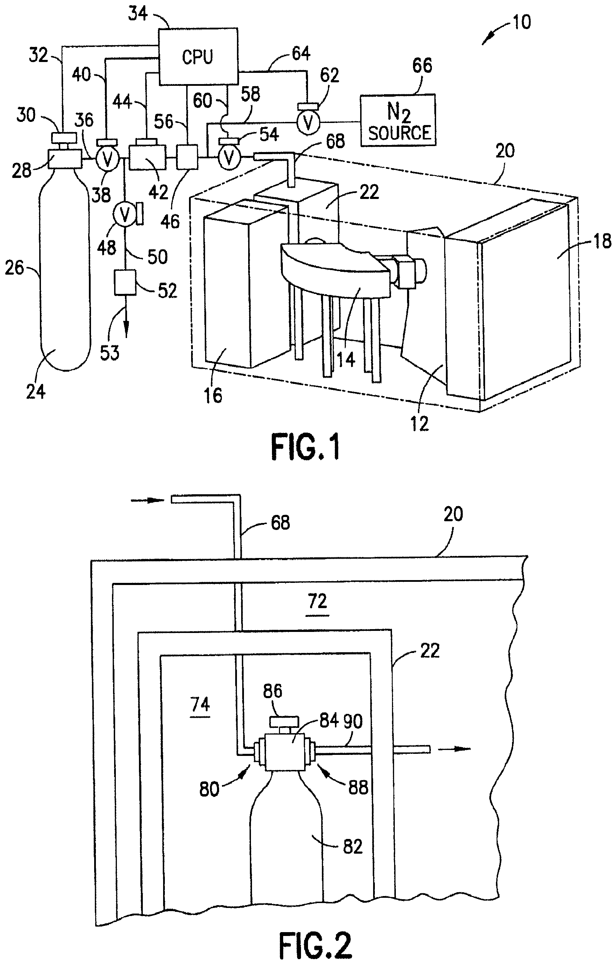

FIG. 1 is a schematic representation of an ion implantation system utilizing a dopant feed gas supply arrangement according to one embodiment of the present disclosure.
FIG. 2 is a schematic representation of a portion of a gas box of an ion implantation system of the type shown in FIG. 1, showing the on-board dopant source gas storage and dispensing vessel, and a portion of the flow circuitry involved in supplying dopant source gas to such storage and dispensing vessel during downtime of the ion implantation system.

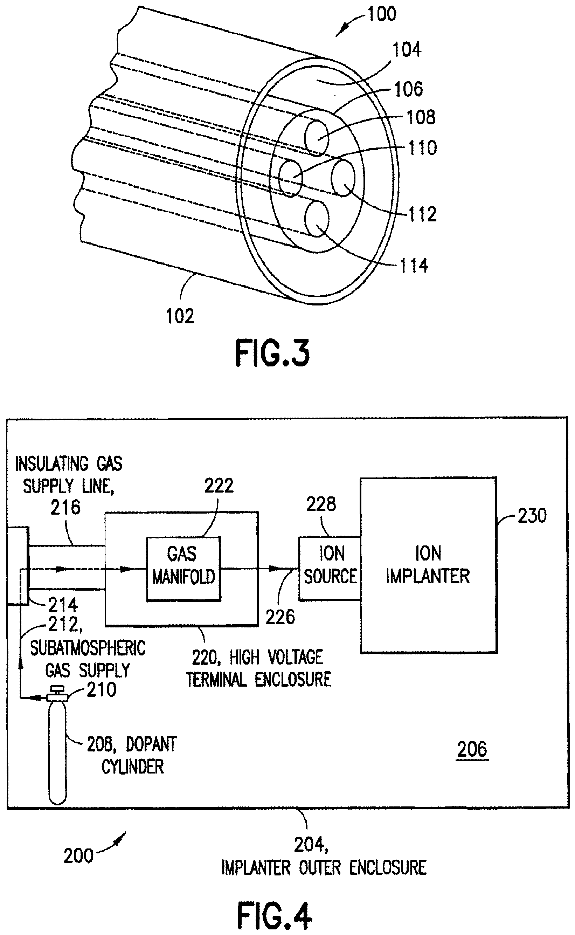

FIG. 3 is a schematic representation of a supply line of a type accommodating multiple supply vessels and multiple local vessels in flow communication with one another, in which the supply line comprises a conduit enclosing a central rod structure, and wherein the central rod structure contains multiple passages therein for flow of multiple streams of gas through the respective passages.
FIG. 4 is a schematic representation of an ion implantation system known from the prior art, and not forming part of the invention, utilizing an on-board dopant source gas storage and dispensing vessel within the ion implanter outer enclosure and outside the high voltage terminal enclosure containing a gas manifold configured to flow dopant feed gas to the ion source chamber.

### DETAILED DESCRIPTION

The present disclosure relates to apparatus and method for supplying dopant source gas to an ion implantation system in a manner that enhances the operational efficiency and on-stream time of the ion implantation system. Dopant source gas supply arrangements and methods are described more fully hereinafter, wherein one or more dopant source gas supply vessels is contained inside an outer enclosure of an ion implantation system, in a gas box within such enclosure.

The disclosure relates in various aspects to a dopant source gas supply apparatus for delivery of a dopant source gas to an ion implantation tool from a gas box that is at elevated operational voltage relative to ground, wherein the gas box and ion implantation tool are in an outer enclosure, and the dopant source gas supply apparatus is arranged in an arrangement comprising: a dopant source gas supply vessel adapted to be positioned in remote relationship to the gas box of the ion implantation system, outside the outer enclosure; a dopant source gas local vessel adapted to be positioned in the gas box; and a supply line interconnecting the dopant source gas supply vessel in supply relationship to said dopant source gas local vessel and adapted to flow dopant source gas from the supply vessel to the local vessel only when the ion implantation tool is in a non-operational state and the gas box is not at said elevated operational voltage.

Another aspect of the disclosure relates to an ion implantation system including an outer enclosure containing a gas box and an ion implantation tool adapted to receive dopant source gas from the gas box, in which the ion implantation system comprises the dopant source gas supply apparatus as described hereinabove, i.e. wherein the dopant source gas supply apparatus is arranged in the above arrangement.

The disclosure in a further aspect relates to a method of ion implantation, comprising use of the dopant source gas supply apparatus as hereinabove described. Such method can for example be conducted in a process for manufacturing a product article selected from the group consisting of semiconductor product articles, flat panel display product articles, and solar energy product articles.

The disclosure therefore contemplates dopant source gas supply in ion implantation systems, in which, according to one embodiment, the dopant source gas is provided to the ion implantation system from a remote supply vessel to a local vessel in the gas box of the ion implantation system. In such arrangement, the local vessel in the gas box of the ion implantation system is appropriately sized for extended operation, and the remote supply vessel and local vessel are arranged for filling of the local vessel from the remote supply vessel only when the ion implantation system is in a non-operational state.

It is noted that as used herein and in the appended claims, the singular forms "a", "and", and "the" include plural referents unless the context clearly dictates otherwise.

According to the invention, the dopant source gas supply apparatus for an ion implantation system includes a gas box. Such apparatus includes: a dopant source gas supply vessel adapted to be positioned in remote relationship to the gas box of the ion implantation system; a dopant source gas local vessel adapted to be positioned in the gas box of the ion implantation system; and a supply line interconnecting the dopant source gas supply vessel in supply relationship to the dopant source gas local vessel and adapted to flow dopant source gas from the supply vessel to the local vessel only when the ion implantation system is in a non-operational state. According to the invention, the supply line is adapted to be evacuated when the ion implantation system is in an operational state.

Such adaptation of the supply line to flow dopant source gas only when the ion implantation system is in a non-operational state, and adaptation to be evacuated when the ion implantation system is in an operational state, is effected by an assembly including a central processor unit (CPU) arranged to control flow of the dopant source gas through the supply line.

The CPU may be arranged for such purpose in an appropriate manner, e.g., wherein the CPU is operatively coupled with at least one valve controlling flow of the dopant source gas through the supply line, e.g., at least one valve in the supply line. Additionally, the at least one valve can include a flow control valve in a valve head of the dopant source gas supply vessel.

The CPU can be adapted to monitor the ion implantation system, and to effectuate the filling of the local vessel(s) in the gas box when the ion implantation system is powered down and in a non-operational state, and to prevent power up of the ion implantation system until after the local vessel filling operation is completed, by CPU generation of control signals that are transmitted to corresponding controlled components such as valves, flow controllers, etc.

The supply line can be constructed of any suitable material, and can for example be constructed of insulative material such as polytetrafluoroethylene or other nonconductive polymer, glass, ceramic or composite material. The supply line may include a single conduit, or alternatively can comprise a coaxial double conduit or other multiple conduit arrangement. A gas purging assembly may be provided for purging the supply line of dopant source gas, after transfer of dopant source gas for filling of the local vessel(s) in the gas box of an ion implantation system.

The supply vessel utilized in the practice of the present disclosure can be of any suitable type. In one embodiment, the supply vessel comprises a pressure-regulated gas storage and dispensing vessel. According to the invention, the local vessel comprises a gas storage and dispensing vessel containing a physical adsorbent having sorptive affinity for the dopant source gas.

The source gas supply apparatus of the present disclosure can be adapted for use with any suitable dopant source material or with a cleaning material for in-line cleaning of the ion implantation system, e.g., cleaning agents such NF₃ or XeF₂. For example, the dopant source material may include a dopant source gas selected from the group consisting of arsine, phosphine, boron trifluoride, di-boron tetrafluoride, germanium tetrafluoride, silicon tetrafluoride and silane. The present disclosure contemplates mixtures of dopant materials, as well as dopant source gas compositions containing a co-flow agent in addition to the dopant source gas. The co-flow agent may include gas species to enhance the nature and extent of the ionization of the dopant source gas, to effect cleaning of the ion implantation system, or otherwise to benefit the operation of the ion implantation system and ion implantation processes carried out therein. In one embodiment, the co-flow agent includes xenon difluoride, to effect in situ cleaning of the ion source.

The disclosure in a further aspect contemplates an ion implantation system comprising the dopant source gas supply apparatus described above.

The disclosure in a method aspect contemplates a method of operating an ion implantation process system including a gas box, in which such method includes disposing a dopant source gas storage and dispensing local vessel in the gas box, coupling the dopant source local gas storage and dispensing vessel with a dopant source gas supply vessel positioned in remote relationship to the gas box by a supply line, and flowing dopant source gas from the supply vessel to the local vessel only when the ion implantation process system is in a non-operational state.

According to the invention, the method includes maintaining the supply line in an evacuated condition during operation of the ion implantation process system involving energization of an ion source in the ion implantation process system. The method can be conducted with a supply vessel including a pressure-regulated gas storage and dispensing vessel. The local vessel is a gas storage and dispensing vessel containing a physical adsorbent having sorptive affinity for the dopant source gas. A preferred embodiment of such method includes the provision of a pressure-regulated gas storage and dispensing supply vessel, interconnected by the supply line with said local vessel containing a physical adsorbent having sorptive affinity for the dopant source gas. The method can be carried out with any suitable dopant source gas species, such as arsine, phosphine, boron trifluoride, di-boron tetrafluoride, etc., and can be carried out with a co-flow agent being supplied from the supply vessel together with the dopant source gas, as described hereinabove.

As used herein, the term "remote" in characterization of the supply vessel used for filling of the local vessel in the gas box of the ion implantation system, means that the supply vessel is located outside the gas box and at least 2 meters from the local vessel in the gas box. In various embodiments of the present disclosure, the supply vessel may be located at least 5, 10, 15, 20, 25, 30, 40, 50 meters or more from the local vessel in the gas box of the ion implantation system.

According to the invention, the ion implantation system includes a system enclosure, in which is disposed the gas box, the ion source, magnets, beamline passageway, pumps and other components of the ion implantation system, so that the system includes a unitary housing for at least the major components of the ion implantation system. The supply vessel is located outside of such unitary housing. For example, the supply vessel can be located in a below-floor vault in a semiconductor manufacturing facility, and coupled by suitable flow circuitry with the local vessel in the gas box of an ion implantation system. Alternatively, the supply vessel can be located in a central location on a main floor of a semiconductor manufacturing facility and coupled by suitable flow circuitry with the local vessel of an ion implantation system.

As another alternative, the supply vessel may be operatively linked by suitable flow circuitry with multiple local vessels in respective ion implantation system units in a semiconductor manufacturing facility, so that multiple implant tools are supplied with dopant source gas by a single supply vessel.

The supply line interconnecting the supply vessel with the local vessel in a gas box of an ion implantation system is adapted to flow dopant source gas from the supply vessel to the local vessel in the gas box for filling of the local vessel from the remote supply vessel only when the ion implantation system is in a non-operational state. The term "non-operational state" refers to the condition of the ion implantation system in which the ion source is not energized and the ion implantation system is at a substantially ground voltage condition.

Since the supply vessel and the local vessel in the gas box of the ion implantation system, and the supply line interconnecting the supply vessel and local vessel, are at ground voltage states during the flow of dopant source gas from the supply vessel to the local vessel, the dopant source gas can be transferred from the supply vessel to the local vessel at extremely low pressure, e.g., sub-atmospheric pressure, without the risk of arcing and plasma discharge in the supply line that would otherwise occur if the local vessel were at high voltage and the supply vessel were at ground potential to produce a corresponding high voltage gradient across the dopant source gas supply line.

Thus, the dopant source gas transfer takes place only when the ion implantation system is in a non-operational state, so that the risk of arcing and plasma discharge is absent in the ground voltage transfer of dopant source gas from the supply vessel to the local vessel in the gas box.

After completion of the transfer of dopant source gas from the supply vessel to the local vessel in the gas box through the supply line, the supply line is evacuated to a low vacuum pressure level to accommodate subsequent power-up and operation of the ion implantation system, wherein the gas box is at the high voltage level of the ion source.

Thereby, the supply line after the completion of filling of the gas box local vessel(s) is maintained under conditions preventing arcing or plasma generation in the supply line during the subsequent on-stream operation of the ion implantation system.

The supply line can be made of any suitable material of construction and can be of any suitable configuration appropriate to the above-described utilization of such fluid transfer structure. In various embodiments, the supply line is constructed of an insulating material accommodating high-voltage operation of the ion implantation system. The supply line may for example be fabricated with a single conduit or coaxial double conduit configuration, and formed of a polymeric material such as polytetrafluoroethylene, polysulfone, polyacetal, etc., or a suitable glass or ceramic material, or other appropriate material of construction having an insulative character. In a coaxial double conduit configuration, the annular volume between the respective conduits may be evacuated, filled with an inert gas at suitable pressure, or continuously purged during transfer of dopant source gas through the inner conduit.

By the foregoing arrangement, the supply line interconnecting the supply vessel with the local vessel in the gas box of the ion implantation system during implanter operation is maintained at sufficient vacuum to allow safe operation of the ion implantation system at suitable voltage, e.g., voltage of from 10 kV to 500 kV or more.

The evacuated condition of the supply line is maintained during the on-stream operation of the ion implantation system. Subsequently, when the ion implantation system is powered down to accommodate regularly scheduled maintenance, or otherwise taken off-line, the dopant source gas supply apparatus and method of the present disclosure can be operated, e.g., under the monitoring and control operation of a CPU, to carry out the filling of the gas box local vessel(s). For example, the supply line, previously maintained under vacuum conditions during the on-stream operation of the ion implantation system can subsequent to power down of the ion implantation system be opened to flow of dopant source gas from the dopant source gas supply vessel, so that dopant source gas flows from the supply vessel to the local vessel in the gas box.

The filling operation then is carried out under the non-operational state of the ion implantation system, to replenish the local vessel in the gas box with dopant source gas, so that the local vessel has an appropriate inventory for extended operation of the ion implantation system until the next scheduled maintenance shutdown, regeneration of cryogenic pumps, or other scheduled interruption of operation of the ion implantation system.

The dopant source gas supply arrangement of the present disclosure comprises components adapted to effect the transfer of dopant supply gas only during a non-operational state of the ion implantation system. Such components may be of any suitable type, and can for example include components such as the following: flow control valve(s) in the supply line, or associated flow circuitry of the supply vessel and/or local vessel; interlock devices that are automatically actuated upon power-up of the ion implantation system to preclude fluid flow through the supply line; a central processor unit (CPU), such as a microprocessor, programmable logic controller (PLC), special-purpose computer programmatically arranged for corresponding operation, or other processor/controller devices, for controlling other components, to effect flow of dopant source gas from the supply vessel to the local vessel only during a non-operational state of the ion implantation system, and preventing flow of dopant source gas from the supply vessel to the local vessel when the ion implantation system is otherwise in operation with the ion source gas box at high-voltage operational conditions; supply line isolation structures that are selectively actuatable to isolate the supply line from fluid flow capability; inert purge gas flushing systems; vacuum pumps; supply vessel isolation components; etc.

The local vessel in the gas box of the ion implantation system is a physical adsorbent-based fluid storage and dispensing vessel enabling storage of the dopant source gas in an adsorbed state in such vessel, and desorption of the dopant source gas from the adsorbent, under dispensing conditions. The physical adsorbent may for example comprise an activated carbon adsorbent in a bead or pyrolyzed monolith form, having appropriate sorptive capacity to accommodate extended operation of the ion implantation system before recharging of the local vessel from the supply vessel is required. Physical adsorbent-based fluid storage and dispensing vessels of such type are commercially available from ATMI, Inc. (Danbury, Connecticut, USA) under the trademark SDS. Such physical adsorbent-based vessels enable the dopant source gas to be stored in an adsorbed state on the adsorbent at low pressure, e.g., sub-atmospheric pressure in a range of from 3 to 95 kPa, and thereby achieve a high level of safety in operation of the ion implantation system.

The local vessel may be of a size and dopant source gas storage capacity for extended operation of the ion implantation system involving dispensing of the dopant source gas. The size and dopant source gas storage capacity of the local vessel may for example be selected to accommodate the period of operation between routine scheduled maintenance of the ion implantation system.

The dopant source gas supply apparatus and method of the present disclosure can also be applied when a plurality of local vessels is supplied with dopant source gas from a single supply vessel. In this respect, the semiconductor manufacturing facility may include numerous ion implantation systems as separate process tools in the facility, each with an associated maintenance schedule whose frequency is dependent on the type of the tool, the specific dopant source gases employed, the ion source operating conditions, and other relevant process system variables.

The regular maintenance schedules for ion implantation systems may vary from a period of days to weeks, and in accordance with the present disclosure, the local vessel in a specific ion implantation system will be correspondingly selected to provide a capacity accommodating the period between such scheduled maintenance events. A local vessel may for example be sized and provided with adsorbent accommodating a 2-4 week supply of dopant source gas to be dispensed to the ion source during on-stream operation of the ion implantation system between scheduled maintenance events.

Although the foregoing discussion has been illustratively directed primarily to a local vessel in a gas box of an ion implantation system, it will be recognized that the gas box can contain multiple local vessels that are serviced by a supply vessel in accordance with the present disclosure. For such purpose, the multiple local vessels can be manifolded or otherwise arranged with suitable circuitry so that the vessels in the gas box are capable of being switched over when a first local vessel approaches exhaustion, so that such local vessel was taken off-stream and a second local vessel filled with dopant source gas then is placed on-stream to supply the ion source of the ion implantation system.

In such multiple local vessel arrangement, the supply vessel exterior of the gas box can be arranged so that the supply line is coupled with a manifold interconnecting the respective local vessels, whereby the local vessels may be concurrently charged with dopant source gas, for subsequent on-stream operation, with the dopant source gas dispensing from the first vessel in the gas box being switched over to dispensing from the second vessel at a predetermined level of exhaustion of the first vessel.

The local vessel in the gas box can therefore be provided with a 2-4 week inventory of dopant source gas, stored on the adsorbent in such local vessel at sub-atmospheric pressure conditions. The local vessel can be arranged for temperature and pressure monitoring, and such vessel can be designed to facilitate heat dissipation for thermal management of the vessel. The vessel can be permanently installed in the gas box, or alternatively may be of a removable character.
While the disclosure herein is illustratively directed to a simplified arrangement of a single supply vessel coupled in downtime only flow communication with a single local vessel in a gas box of an ion implantation system, it will be appreciated that the disclosure is not thus limited. Arrangements are contemplated in which multiple local vessels are provided in the gas box of an ion implantation system for different gases, e.g., arsine, phosphine, boron trifluoride, etc., which can be simultaneously refilled during down time of the ion implanter system, through a supply line that is arranged with multiple separate passages for such purpose. In one embodiment, the supply line comprises a conduit enclosing a central rod structure, wherein the central rod structure contains multiple passages therein for flow of multiple streams of gas through the respective passages.

Alternatively, multiple separate supply lines can be provided, each interconnecting a single supply vessel and a single local vessel in the gas box.

As a still further alternative, multiple local vessels in the gas box can be adapted to receive a same gas for subsequent, sequential dispensing to the ion source, by suitable valving, manifolding and switchover systems enabling a first vessel to be utilized for a first period of time during the on-stream period of operation of the ion implantation system, and when such first vessel is depleted of gas to a predetermined extent, the switchover system will switch out the first vessel and initiate dispensing of the same gas from a second vessel, thereby providing extended dispensing capability during the on-stream operation of the ion implantation system.

The supply vessel that is utilized to provide dopant source gas to one or more local vessels in one or more ion implantation systems, can be of any suitable type that provides adequate capacity for supplying dopant source gas to the local vessel(s) of the ion implantation system(s), including conventional high pressure gas cylinder supply vessels, pressure-regulated gas storage and dispensing supply vessels, and adsorbent-based gas storage and dispensing supply vessels.

In various preferred embodiments, the supply vessel is a pressure-regulated gas storage and dispensing vessel including one or multiple internally disposed gas pressure regulator(s), of a type as commercially available from ATMI, Inc. (Danbury, Connecticut, USA) under the trademark VAC. Pressure-regulated vessels of such type can be arranged with appropriate set point pressures of the internal regulators, to provide low pressure supply of dopant source gas to the local vessels of corresponding ion implantation systems, to provide enhanced safety in the dispensing of the dopant source gas to the vessels in the gas boxes of the associated ion implantation system tools. By way of illustration, the supply vessel may be pressure regulated to supply dopant source gas at pressure in a range of from 65 to 90 kPa to the local vessel in the gas box.

As a further safety enhancement, the supply vessel may be deployed in a gas cabinet that is ventilated, with ventilation gas flow therethrough at a suitable rate to sweep any leakage out of the gas cabinet, e.g., in a stream that is passed to an air exhaust treatment unit of a semiconductor manufacturing facility. The supply vessel additionally may be coupled with a dispensing manifold that is constructed and arranged to isolate the supply vessel in the event of an overpressure condition. Overpressure fluid storage and dispensing vessel isolation arrangements may be employed, of a type as described in U.S. Patent 6,857,447.

The supply vessel can be of any suitable size and capacity that is appropriate for providing dopant source gas to the local vessel(s) that are coupled in fluid-receiving relationship to the supply vessel. The supply vessel can for example have a volumetric capacity exceeding 40 L, e.g., 50 L, 100 L or more, as may be necessary or desirable in a given semiconductor manufacturing facility in which a dopant source gas supply arrangement of the present disclosure is employed.

Thus, in accordance with the present disclosure, the replenishment of dopant source gas in the gas box of the ion implantation system can be carried out at sub-atmospheric pressure conditions from a remote, central supply vessel, and such replenishment can be scheduled/integrated to coincide with maintenance periods, cryogenic pump regeneration periods, or other times when the ion implantation system is powered down, and in a non-operational state. By such deployment, fluid replenishment transfers are coincident with downtimes for the ion implantation system, and fluid replenishment is carried out when the gas box of the ion implantation system is not at high potential relative to ground.

It will therefore be apparent that the dopant source gas supply arrangements of the present disclosure afford significantly enhanced safety in the provision, handling and use of dopant source gases in semiconductor manufacturing operations involving ion implantation. The dopant source gas can be provided in the first instance from a supply vessel that is remote from the ion implantation system, and centralized to service one or more ion implantation systems in a semiconductor manufacturing facility. The dopant source gas supply line can be permanently installed, so that no disconnection of toxic gas lines, donning of SCBA equipment, or clearing of facility premises is required between regularly scheduled maintenance events for the ion implantation system. Further, the charging of onboard vessels in the gas box of the ion implantation system can be coordinated with such regularly scheduled maintenance events so that an ample quantity of dopant source gas is charged to the gas box vessels, under non-operational conditions, to enable extended operation until the next succeeding regularly scheduled maintenance event. The ion implantation system thereby is enabled for continued and continuous operation, without the attendant necessity for unscheduled shutdowns to accommodate changeout of fluid vessels in the gas box.

Referring now to the drawings, FIG. 1 is a schematic representation of an ion implantation system 10 utilizing a dopant feed gas supply arrangement according to one aspect of the present disclosure. The ion implantation system 10 includes an ion implantation system enclosure 20 containing ion implant process chamber 12 and beam launch 14, control cabinet 16, gas box 22, and end station, stocker and mini-environment 18.

The gas box 22 as shown is connected in fluid flow communication with inlet conduit 68. The inlet conduit 68 constitutes, together with the dopant source gas feed line 36, a supply line for flowing dopant source gas from supply vessel 24 to the local vessel in gas box 22, as more fully described hereinafter, with reference to FIG. 2.

The dopant source gas supply vessel 24 is suitably of a type equipped with an internally disposed regulator assembly responsive to pressure at the discharge port of the vessel, with respect to pressure set point(s) of one or more regulator devices in the regulator assembly. Vessels of such type are commercially available from ATMI, Inc. (Danbury, Connecticut, USA) under the trademark VAC.

Alternatively, the vessel may be of a type including in an interior volume thereof a physical adsorbent material on which the dopant source gas is stored and from which the dopant source gas is desorbed and dispensed from the vessel under dispensing conditions. Vessels of such type are commercially available from ATMI, Inc. (Danbury, Connecticut, USA) under the trademark SDS.

As a still further alternative, the dopant source gas supply vessel 24 may comprise a high pressure gas cylinder.

Although not schematically shown, for ease of description, it will be appreciated that the dopant source gas supply vessel 24 may be provided in a gas cabinet, or in a gas supply vault, or in other segregated area. of a semiconductor manufacturing facility.

The dopant source gas supply vessel 24 as illustrated includes a vessel casing 26, at the neck portion of which is secured a valve head 28, including a valve element (not shown) that is selectively translatable between fully open and fully closed positions, to modulate flow of the dopant source gas discharged from the vessel. Coupled with the valve head 28 is a valve actuator 30, arranged to actuate the valve element in the valve head 28. The valve actuator 30 is controlled by signal transmission from the CPU 34, as transmitted through the signal transmission line 32.

The dopant source gas feed line 36 is coupled to the discharge port of the valve head 28, and contains feed line flow control valve 38, coupled in controlled relationship to the CPU 34 by signal transmission line 40, mass flow controller 42, coupled in controlled relationship to the CPU 34 by signal transmission line 44, pressure monitoring device 46, e.g., a pressure transducer, coupled in signal transmission relationship to CPU 34 by signal transmission line 56, whereby pressure may be monitored and a monitoring signal sent to the CPU indicative of the pressure of dopant source gas in the feed line 36, and feed line flow control valve 54, coupled in controlled relationship to the CPU 34 by signal transmission lines 60.

The dopant source gas feed line 36 is joined in flow communication with purge line 50, containing flow control valve 48 therein. The purge line 50 contains a vacuum pump 52 to facilitate purging of the feed line 36, and discharge of purge gas effluent from the system in vent line 53. It will be appreciated that in addition to purging capability for the feed line, the supply and/or local vessels may be adapted, e.g., by valving, manifolding, flow lines, etc., for purging and refilling with "fresh" materials.

Purging of the feed line 36 is effected by flow of gas from a nitrogen source 66 in nitrogen purge feed line 58 , containing flow control valve 62 therein. The flow control valve 62 is coupled in controlled relationship to CPU 34 by signal transmission line 64, whereby the flow of nitrogen gas to the feed line 36 can be effected by opening of flow control valve 62 to initiate purging, and with the flow control valve 62 being closed upon completion of purging by a corresponding control signal from CPU 34 transmitted in signal transmission line 64 to such flow control valve.

Although not shown for ease of description, the CPU 34 is advantageously coupled to the ion implantation system, so as to generate an input to the CPU when the ion implantation system is powered down, e.g., for regularly scheduled maintenance, regeneration of cryogenic pumps, or other event involving cessation of ion implantation system operation. The CPU 34 then operates to initiate replenishment of the local dopant gas source vessel in the gas box 22, by opening the valve in the valve head 28 of supply vessel 24 (by actuation of valve actuator 30 via transmission of a corresponding control signal to the actuator in signal transmission line 32), and by opening flow control valves 38 and 54 by transmission of control signals to such valves in respective signal transmission lines 40 and 60. Concurrently, the mass flow controller 42 may be modulated by a control signal from the CPU 34 transmitted in signal transmission line 44 to such controller. The pressure of dopant source gas in feed line 36 is monitored by pressure monitor 46 and a pressure monitoring signal is correlatively generated and transmitted in signal transmission line 56 to the CPU 34, which can responsively modulate the valve in valve head 28, flow control valves 38 and 54, and mass flow controller 42, by appropriate signal transmission in corresponding signal transmission lines.

The flow control valves 62 and 48 are closed at this time. Dopant source gas flows from the supply vessel 24 through feed line 36 and inlet conduit 68 to replenish the inventory of dopant source gas in the local vessel in gas box 22, with the ion implantation system being in a non-operational state.

Subsequent to the desired charging of the local vessel in gas box 22, the CPU 34 transmits control signals in signal transmission lines 32, 40, and 60, to close the associated valve in valve head 28, and flow control valves 38 and 54. The CPU 34 then operates to open previously closed valves 62 and 48 (the signal transmission line from CPU 34 to flow control valve 48 not being shown in FIG. 1), so that nitrogen purge gas flows from the nitrogen source 66 through nitrogen purge gas feed line 58, dopant source gas feed line 36 and through vacuum pump 52 in purge gas discharge line 50, with discharge of purge gas effluent in vent line 53.

In an alternative not forming part of the claimed invention, subsequent to purging, the dopant source gas feed line 36 may be filled with nitrogen gas from a nitrogen source 66, with closure of flow control valve 48, so that the feed line is pressurized with the nitrogen gas. The fill of the feed line with nitrogen gas is carried out to a desired pressure level precluding arcing and plasma formation in the feed line 36 during subsequent on-stream operation of the ion implantation system. Flow control valve 62 then is closed to maintain such pressurized nitrogen condition in the feed line 36 for the subsequent on-stream operation of the ion implantation system.

According to the invention, flow control valve 62 is closed, with closure of flow control valves 38 and 54, but with flow control valve 48 open and vacuum pump 52 operating to pump out the feed line 36 between flow control valves 38 and 54, until a suitably low vacuum pressure level is achieved. Following such evacuation, the flow control valve 48 is closed and pump 52 shut off. In this manner, vacuum pressure conditions are maintained in the feed line 36 during subsequent on-stream operation of the ion implantation system, to prevent arcing and plasma generation in the feed line 36.

By the above-described arrangement, the local vessel in the gas box 22 is replenished with dopant source gas only during downtime periods, when the ion implantation system is in a non-operational state, and no dopant source gas is supplied from supply vessel 24 during the subsequent on-stream operation of the ion implantation system.

FIG. 2 is a schematic representation of a portion of a gas box 22 of an ion implantation system of the type shown in FIG. 1, showing the on-board dopant source gas storage and dispensing vessel 82, and a portion of the flow circuitry involved in supplying dopant source gas to such storage and dispensing vessel during downtime of the ion implantation system.

As illustrated, the gas box 22 is disposed in an interior volume 72 of the ion implantation system enclosure 20. The local vessel 82 is positioned in the interior volume 74 of the gas box 22. The local vessel includes a fill port 80 coupled to inlet conduit 68 for replenishment of dopant source gas when the ion implantation system is in a non-operational state, as previously described in connection with FIG. 1. The local vessel 82 includes a valve head 84 to which is coupled a valve actuator 86. The valve head includes a discharge port 88 to which is coupled a dopant source gas discharge line 90 for flowing a dopant source gas to the ion source (not shown in FIG. 2) of the ion implantation system. The valve actuator 86 can be coupled to a CPU such as CPU 34 in FIG. 1, for purposes of controlling the flow rate of the dopant source gas to the ion source of the ion implantation system.

FIG. 3 is a schematic representation of a supply line of a type accommodating multiple supply vessels and multiple local vessels in flow communication with one another, in which the supply line comprises a conduit enclosing a central rod structure, and wherein the central rod structure contains multiple passages therein for flow of multiple streams of gas through the respective passages.

As illustrated, the supply line 100 includes conduit 102 containing rod 106. The rod is coaxial in the interior volume of the conduit 102, and forms with the conduit and an annular volume 104. The rod 106 contains passages 108, 110, 112 and 114 therein. Each of such passages in the rod can accommodate the flow of a different dopant source gas therethrough, whereby multiple supply vessels and multiple local vessels can be accommodated. The annular volume 104 between the rod 106 and the conduit 102 can be evacuated, or such annular volume 104 can be pressurized with an inert gas, during on-stream operation of the ion implantation system when gas is not being transmitted from a supply vessel to a local vessel. During downtime of the ion implantation system, the annular volume 104 between the rod 106 and the conduit 102 can also be utilized as a further flow passage, for transmission of dopant source gas from a supply vessel to a local vessel in the gas box of an ion implanter system.

The conduit 102 and rod 106 of the supply line 100 of FIG. 3 can be fabricated of polytetrafluoroethylene or other suitable material of construction.

In an illustrative embodiment of an ion implantation system of the type shown in FIGS. 1 and 2, the system can be arranged for downtime flow of dopant source gas from the supply vessel to the local vessel in the gas box of 2-4 weeks supply of dopant source gas. For a system of such type utilizing arsine as an arsenic dopant source, such 2-4 weeks supply of dopant source gas may be on the order of 30 to 100 g of arsine. For a corresponding system utilizing phosphine as a phosphorus dopant source, such 2-4 weeks supply of dopant source gas may be on the order of 12 to 100 g of phosphine. For boron trifluoride, such 2-4 weeks supply of dopant source gas may be on the order of from 70 to 200 g of BF₃.

It will be recognized that fluid supply systems of the type illustratively shown and described herein can be modified and varied in numerous ways, in relation to the specific structures and arrangements and methods discussed hereinabove. For example, the gas box of the ion implantation system may be provided with ventilation capability, so that air exhaust or other gas, such as clean dry air (CDA), is flowed through the gas box to sweep out any leakage of dopant source gas or other gas occurring in the gas box. In such system arrangement, the ventilation apparatus may be adapted to increase ventilation gas flow rate during downtime fill of local vessels in the gas box, to accommodate the fill operation, or to otherwise modulate flow rate of sweep gas during the fill and subsequent on-stream operation of the ion implantation system.

As a further modification, the supply line may be adapted for varied directional flow operation, including countercurrent flow of purge gas through the supply line, in a direction reversed to that of the flow of dopant source gas from the supply vessel to the local vessel in the gas box during the fill operation, as well as for reverse flow of the sorbate gas, so that sorbate gas is removed from the local vessel in the gas box, as for example may be advantageous to permit sorbent material to be changed out from a sorbent-containing local vessel in the gas box, or for otherwise removing sorbate gas from the local vessel if the process recipe (dopant) for the ion implantation operation in the ion implantation system is changed.

During the downtime of the ion implantation system, it may be necessary to allow the ion implantation system to at least partially cool, prior to initiation of the fill operation. This may be particularly desirable if the physical adsorbent in an adsorbent-containing local vessel has become significantly heated during immediately preceding on-stream operation. In such instances, cooling of the physical adsorbent will increase its sorptive capacity for the dopant source gas. For such purpose, it may be advantageous to flow a cool inert purge flow into and out of the local vessel to remove heat from the vessel and physical adsorbent, and/or to flow cooled dopant source gas from the remote supply vessel through the supply line to the local vessel, to compensate for any thermal issues and to maximize adsorption in the local vessel on the physical adsorbent therein.

The downtime fill of the local vessels when containing physical adsorbent may be carried out in any suitable manner. For example, the fill process may be carried out until a specific predetermined pressure is attained in the vessel, whereupon the flow of dopant source gas to the local vessel is temporarily stopped to allow adsorption equilibration to occur. During this time, pressure in the vessel may be monitored, e.g., either absolute pressure or rate of pressure change with time, and when the pressure or pressure drop rate reaches a specific value, the flow of dopant source gas to the local vessel can be restarted and continued until a specific pressure or pressure drop rate is reached, with continued repetition of this process, if and as needed, until the fill operation is complete.

It will be recognized that various flow rate-time-pressure relationships can be utilized in the fill operation, in respect of the associated adsorbent uptake of dopant source gas, dissipation of heat adsorption effects, thermal equilibration, etc., to achieve a desired fluid loading on the physical adsorbent and a predetermined dopant source gas inventory in the local vessel for subsequent on-stream operation of the ion implantation system.

FIG. 4 is a schematic representation of an ion implantation system 200 known from the prior art (e.g. US 6515290B; Fig. 2), and not forming part of the invention, utilizing an on-board dopant source gas storage and dispensing vessel 208 within the interior volume 206 of the ion implanter outer enclosure 204 and outside the high voltage terminal enclosure 220 containing a gas manifold 222 configured to flow dopant feed gas to the ion source chamber 208.

The dopant source gas storage and dispensing vessel 208 may be of cylindrical container portion that is coupled to a valve head assembly 210. The valve head assembly may include a manual handwheel that is actuatable to open a valve in the valve head to initiate flow of dopant source gas to the gas feed line 212. Alternatively, the valve head assembly may include an automatic valve actuator, which may in turn be joined to a monitoring and control assembly (not shown in FIG. 4) that is arranged to open the valve in the valve head to initiate the flow of the dopant source gas to the gas feed line 212.

The gas feed line 212 is arranged to flow dopant source gas into the inlet 214 of the insulating gas supply line 216, so that the dopant source gas flows through such gas supply line to the high voltage terminal enclosure 220. A gas manifold is disposed in the high voltage terminal enclosure 220 and configured to deliver gas into the delivery line 226 for flow to the ion source. In the ion source, the dopant source gas is ionized to generate an ion beam. The ion beam thus generated passes into the ion implanter 230, being accelerated by electric field to implant ions into a substrate.

By the illustrative arrangement depicted in FIG. 4, the dopant source gas is able to be provided within the implantation system outer enclosure 204 to that it is maintained at ground voltage. The insulating gas supply line is fabricated of an electrically insulating material so that the dopant source gas can "jump the voltage gap," passing into the high voltage terminal enclosure and gas manifold flow circuitry therein for subsequent delivery to the ion source chamber.

The dopant source gas in FIG. 4 may be of any suitable type, and may for example comprise B₂F₄, diborane, boron trifluoride, or a dopant source gas mixture, e.g., a mixture of B₂F₄ and diborane. The dopant source gas can be isotopically enriched, or contain a dopant source gas mixture at least one of the components of which is isotopically enriched.

The foregoing arrangements overcome the problems of storing ion source dopant gas supplies at high voltage potential in the ion implantation system. These problems include: the requirement that expensive space in the high voltage terminal enclosure has to be designed in the ion implantation system by the original equipment manufacturer of such system; the corresponding limitation on size and weight of the dopant source gas supply vessel in the high voltage terminal enclosure; and the need for manual replacement of the dopant source gas supply vessels in the high voltage terminal enclosure, involving self-contained breathing apparatus (SCBA) and requiring local area evacuation. These problems are particularly acute in the case of ion sources that consume large volumes of dopant source gas and require high volumetric flow rates, e.g., ion sources for high surface area implant applications such as flat panel displays or solar panels.

The above-described approach enables one or more than one dopant source gas supply vessel to be located at ground potential inside the implanter outer enclosure, rather than inside the high voltage terminal enclosure. The supply vessels may be of any suitable type, and may for example comprise adsorbent-based vessels in which the dopant source gas is stored in an adsorbed state, and is desorbed from the adsorbent under dispensing conditions. Vessels of such type are commercially available from ATMI, Inc. (Danbury, CT, USA) under the trademark SDS. Alternatively, the supply vessels may comprise internally pressure-regulated dopant source gas supply vessels, such as those commercially available from ATMI, Inc. (Danbury, CT, USA) under the trademark VAC. Such SDS® and VAC® vessels are usefully employed to deliver dopant source gas at sub-atmospheric pressure.

The dopant source gas supply vessel as shown in FIG. 4 thus can be configured to deliver dopant source gas at sub-atmospheric pressure, being connected to an insulating gas supply line that enables the gas to cross the voltage gap into the high voltage terminal. The connection lines between the cylinders and the insulating gas supply line are preferably short in order to avoid excessive pressure drops.

In such arrangement, there may be one or more dopant source gas supply vessels of one gas type inside the implanter outer enclosure, or there may multiple dopant source gas supply vessels of multiple gas types with multiple connection lines and multiple insulating gas supply lines, whereby a specific one of multiple dopant source gases, or specific mixtures of different dopant source gases, can be delivered to the manifold in the high voltage terminal enclosure. All dopant source gas supply vessels may be located in the implanter outer enclosure, or alternatively some dopant source gas supply vessels may be located in the implanter outer enclosure with others being located inside the high voltage terminal enclosure. In other words, the high voltage terminal enclosure can be utilized as a gas box in an arrangement of the general type described in connection in with the FIG. 2 embodiment, wherein one or more local supply vessels is contained in the gas box and refilling dopant source gas is delivered to the local supply vessels from the remote supply vessels, with the remote supply vessels, in contrast to the FIG. 2 embodiment, being inside the implanter outer enclosure.

The pressure inside the insulating gas supply line is advantageously sub-atmospheric in order to enhance safety, but must be sufficiently high to ensure that high voltage breakdown does not occur. Depending on the dopant source gas type, the length of the insulating gas supply line, and the voltage applied, the pressure inside the insulating gas supply line may range from 0.1 to 0.95 atmospheres, 1 atmosphere being 101,3 kPa.

Since the gas connection lines (e.g., gas feed line 212 in FIG. 4) are metal, and the insulating gas supply line is made of electrically insulating material (e.g., glass, ceramic, polytetrafluoroethylene, etc.), an appropriate seal must be provided between the two materials. The nature of the seal (e.g., glass-metal, ceramic-metal, O-ring, etc.) must therefore be appropriately selected to minimize the risk and danger of leakage and/or breakage, particularly in the use of highly toxic or corrosive dopant gases.

The safety advantages of the above-described configuration shown in FIG. 4 include the following: (i) pressure in the metal supply line(s) and insulating gas supply line is sub-atmospheric, so that any leakage will occur from the outside into the gas supply system, rather than from the gas supply into the ambient environment; (ii) the dopant source gas supply vessels are arranged for sub-atmospheric pressure supply of fluid, with intrinsically limited leakage rates; and (iii) the entire gas supply and delivery system is contained within an existing vented enclosure, viz., the implanter's outer ground enclosure.

When the local supply vessel in the gas box is utilized with a remote bulk supply vessel, arranged for filling of the local supply vessel in the gas box by the remote supply vessel during periods of "non-voltage" operation (i.e., when the gas box is not at elevated electrical potential relative to ground potential), it may be advantageous to utilize as a remote vessel an internally pressure-regulated vessel, such as the VAC^{®} vessel previously described, with the local dopant gas supply vessel being an adsorbent-based fluid supply vessel, such as the aforementioned SDS^{®} fluid supply vessel, in which the dopant supply gas is sorptively held on the adsorbent medium in the vessel, and desorptively released from the adsorbent during dispensing operation.

Alternatively, both the remote supply vessel and the local on-board vessel may be adsorbent-based fluid supply vessels.

Regardless of vessel type, the remote supply vessel(s) providing fluid to the on-board vessel in the gas box may be provided in a gas cabinet, as a separate enclosure component that is locatable in the implantation facility in proximity to the ion implantation system. The vessels in such gas cabinet may be arranged for successive dispensing operation, so that when one of such vessels in the gas cabinet is exhausted or at a predetermined point of depletion, the dispensing is switched to a second (or successive vessel) to provide for continuity of dispensing for fill of local vessels in the gas box of the implantation system.
It will therefore be appreciated that the present disclosure contemplates a variety of potential arrangements for delivery of dopant source gases to an ion implantation tool, and that combinations of the foregoing arrangements are possible. Such arrangements may include dopant source gas vessels in the gas box and within the implanter outer enclosure, as well as outside of the enclosure, for fill of the on-board vessels from a bulk supply or source vessel. Arrangements are also contemplated for filling of on-board gas box vessels between periods of high voltage operation wherein the gas box is at elevated electrical potential, as well as arrangements in which dopant source gas is supplied to the ion implantation tool continuously from a vessel in the gas box that is replenished from an on-board supply vessel, as well as arrangements in which the gas box contains only flow circuitry and gas supplied from a source vessel outside the gas box "jumps the voltage gap" through an insulated dopant source gas supply passage, optionally with a further dopant source gas supply vessel adapted to be positioned outside the outer enclosure, in supply relationship to the source vessel positioned in the outer enclosure, outside of the gas box.

## Claims

1. A dopant source gas supply apparatus for delivery of a dopant source gas to an ion implantation tool of an ion implantation system (10), the apparatus comprising a gas box (22) that in operation is at elevated operational voltage relative to ground, wherein the gas box (22) is in an outer enclosure (20), the outer enclosure being adapted to also contain the ion implantation tool, and the dopant source gas supply apparatus is arranged in an arrangement comprising:
a dopant source gas supply vessel (24) positioned in remote relationship to the gas box of said ion implantation system, outside the outer enclosure (20);
a dopant source gas local vessel (82) positioned in the gas box (22) of said ion implantation system (10); and
a supply line (36, 68) interconnecting the dopant source gas supply vessel (24) in supply relationship to said dopant source gas local vessel (82) and adapted to flow dopant source gas from the dopant source gas supply vessel (24) to the dopant source gas local vessel (82) only when the ion implantation system is in a non-operational state and the gas box (22) is not at said elevated operational voltage;
wherein the dopant source gas local vessel (82) comprises a gas storage and dispensing vessel containing a physical adsorbent having sorptive affinity for the dopant source gas; and
wherein the supply line (36, 68) is adapted to be evacuated when the ion implantation system (10) is in an operational state, by an assembly comprising a central processor unit (34) arranged to control flow of gas through said supply line (36, 68).

2. The dopant source gas supply apparatus of claim 1, wherein said central processor unit (34) is operatively coupled with at least one valve controlling flow of gas through said supply line (36, 68), wherein said at least one valve comprises (i) at least one valve (38) in said supply line, or (ii) a flow control valve in a valve head (84) of said dopant source gas supply vessel (24).

3. The dopant source gas supply apparatus of any one of claims 1 and 2, wherein the supply line (36, 68) comprises a characteristic selected from among the following characteristics:
(i) the supply line being constructed of insulative material;
(ii) the supply line being constructed of polytetrafluoroethylene;
(iii) the supply line comprising a single conduit;
(iv) the supply line comprising a coaxial double conduit.

4. The dopant source gas supply apparatus of any one of claims 1 to 3, further comprising a gas purging assembly (48, 50, 52) for purging said supply line of dopant source gas.

5. The dopant source gas supply apparatus of any one of claims 1 to 4, wherein the supply vessel (24) comprises a pressure-regulated gas storage and dispensing vessel.

6. The dopant source gas supply apparatus of claim 1, wherein the supply line is arranged with multiple passages.

7. An ion implantation system including the dopant source gas supply apparatus of any one of claims 1 to 6.

8. The ion implantation system of claim 7, as adapted for conducting a process for manufacturing a product article selected from the group consisting of semiconductor product articles, flat panel display product articles, and solar energy product articles.

9. An ion implantation method, comprising use of the dopant source gas supply apparatus of any one of claims 1 to 6.

10. The method of claim 9, wherein the use of the dopant source gas supply apparatus comprises operating the ion implantation system (10) including the gas box (22), said method comprising disposing the dopant source gas local vessel (82) in the gas box (22), coupling the dopant source gas local vessel (82) with the dopant source gas supply vessel (24) positioned in remote relationship to the gas box (22) by the supply line (36, 68), and flowing dopant source gas from the supply vessel (24) to the local vessel (82) only when the ion implantation system (10) is in a non-operational state and the gas box (22) is not at said elevated operational voltage.

## Patentansprüche

1. Dotierstoffquellengas-Zufuhrvorrichtung zur Abgabe eines Dotierstoffquellengases an ein Ionenimplantationswerkzeug eines Ionenimplantationssystems (10), wobei die Vorrichtung einen Gaskasten (22) aufweist, der während des Betriebs eine erhöhte Betriebsspannung in Bezug auf die Masse aufweist, wobei sich der Gaskasten (22) in einem äußeren Gehäuse (20) befindet, wobei das äußere Gehäuse derart ausgelegt ist, dass es auch das Ionenimplantationswerkzeug enthält, und die Dotierstoffquellengas-Zufuhrvorrichtung in einer Anordnung angeordnet ist, die Folgendes umfasst:
einen Dotierstoffquellengas-Zufuhrbehälter (24), der in einer entfernten Beziehung zu dem Gaskasten des lonenimplantationssystems angeordnet ist, außerhalb des äußeren Gehäuses (20);
einen lokalen Dotierstoffquellengas-Behälter (82), der in dem Gaskasten (22) des Ionenimplantationssystems (10) angeordnet ist; und
eine Zufuhrleitung (36, 68), die den Dotierstoffquellengas-Zufuhrbehälter (24) in einer Zufuhrbeziehung mit dem dem lokalen Dotierstoffquellengas-Behälter (82) verbindet und ausgelegt ist, Dotierstoffquellengas aus dem Dotierstoffquellengas-Zufuhrbehälter (24) nur dann zu dem lokalen Dotierstoffquellengas-Behälter (82) strömen zu lassen, wenn sich das Ionenimplantationssystem in einem nicht betriebsbereiten Zustand befindet und der Gaskasten (22) nicht bei der erhöhten Betriebsspannung liegt;
wobei der lokale Dotierstoffquellengas-Behälter (82) einen Gasspeicher und einen Abgabebehälter umfasst, der ein physikalisches Adsorptionsmittel mit Sorptionsaffinität für das Dotierstoffquellengas enthält; und
wobei die Zufuhrleitung (36, 68) ausgelegt ist, entleert zu werden, wenn sich das Ionenimplantationssystem (10) in einem betriebsbereiten Zustand befindet, von einer Anordnung, die ein zentrale Verarbeitungseinheit (34) umfasst, die ausgelegt ist, einen Gasstrom durch die Zufuhrleitung (36, 68) zu steuern.

2. Dotierstoffquellengas-Zufuhrvorrichtung nach Anspruch 1, wobei die zentrale Verarbeitungseinheit (34) mit mindestens einem Ventil, das den Gasstrom durch die Zufuhrleitung (36, 68) steuert, betrieblich gekoppelt ist, wobei das mindestens eine Ventil (i) mindestens ein Ventil (38) in der Zufuhrleitung aufweist, oder (ii) ein Strömungssteuerventil in einem Ventilkopf (84) des Dotierstoffquellengas-Zufuhrbehälters (24) aufweist.

3. Dotierstoffquellengas-Zufuhrvorrichtung nach einem der Ansprüche 1 und 2, wobei die Zufuhrleitung (36, 68) eine Eigenschaft umfasst, die aus den folgenden Eigenschaften ausgewählt ist:
(i) die Zufuhrleitung ist aus Isoliermaterial konstruiert;
(ii) die Zufuhrleitung ist aus Polytetrafluorethylen konstruiert;
(iii) die Zufuhrleitung umfasst eine einfache Leitung;
(iv) die Zufuhrleitung umfasst eine koaxiale doppelte Leitung.

4. Dotierstoffquellengas-Zufuhrvorrichtung nach einem der Ansprüche 1 bis 3, ferner umfassend eine Gasspülbaugruppe (48, 50, 52) zum Spülen der Zufuhrleitung von Dotierstoffquellengas.

5. Dotierstoffquellengas-Zufuhrvorrichtung nach einem der Ansprüche 1 bis 4, wobei der Zufuhrbehälter (24) einen druckregulierten Gasspeicher und einen Abgabebehälter umfasst.

6. Dotierstoffquellengas-Zufuhrvorrichtung nach Anspruch 1, wobei die Zufuhrleitung mit einer Vielzahl von Durchgängen angeordnet ist.

7. Ionenimplantationssystem, das die Dotierstoffquellengas-Zufuhrvorrichtung nach einem der Ansprüche 1 bis 6 aufweist.

8. Ionenimplantationssystem nach Anspruch 7, das zum Ausführen eines Prozesses zum Herstellen eines Produktartikels ausgelegt ist, der ausgewählt ist aus der Gruppe bestehend aus Halbleiterproduktartikeln, Flachbildschirmanzeige-Produktartikeln und Sonnenenergie-Produktartikeln.

9. Ionenimplantationsverfahren, umfassend die Verwendung der Dotierstoffquellengas-Zufuhrvorrichtung nach einem der Ansprüche 1 bis 6.

10. Verfahren nach Anspruch 9, die Verwendung der Dotierstoffquellengas-Zufuhrvorrichtung das Betreiben des lonenimplantationssystems (10) umfasst, das den Gaskasten (22) aufweist, wobei das Verfahren das Anordnen des lokalen Dotierstoffquellengas-Behälters (82) in dem Gaskasten (22), Koppeln des lokalen Dotierstoffquellengas-Behälters (82) mit dem Dotierstoffquellengas-Zufuhrbehälter (24), der sich in einer entfernten Beziehung zu dem Gaskasten (22) befindet, durch die Zufuhrleitung (36, 68) und Strömenlassen des Dotierstoffquellengases aus dem Zufuhrbehälter (24) zu dem lokalen Behälter (82) nur dann, wenn sich das Ionenimplantationssystem (10) in einem nicht betriebsbereiten Zustand befindet und der Gaskasten (22) nicht bei der erhöhten Betriebsspannung liegt, umfasst.

## Revendications

1. Dispositif d'alimentation en gaz source de dopant pour fournir un gaz source de dopant à un outil d'implantation d'ions d'un système d'implantation d'ions (10), le dispositif comprenant un conteneur à gaz (22) qui en fonctionnement est a une tension opérationnelle élevée par rapport à la masse, dans lequel le conteneur à gaz (22) est dans une enceinte extérieure (20), l'enceinte extérieure étant adaptée pour contenir également l'outil d'implantation d'ions, et le dispositif d'alimentation en gaz source de dopant est aménagé dans un aménagement comprenant :
un réceptacle d'alimentation en gaz source de dopant (24) positionné éloigné du conteneur à gaz dudit système d'implantation d'ions, en dehors de l'enceinte extérieure (20) ;
un réceptacle local de gaz source de dopant (82) positionné dans le conteneur à gaz (22) dudit système d'implantation d'ions (10) ; et
une conduite d'alimentation (36, 68) interconnectant le réceptacle d'alimentation en gaz source de dopant (24) en relation d'alimentation avec le réceptacle local de gaz source de dopant (82) et adaptée pour faire circuler du gaz source de dopant du réceptacle d'alimentation de gaz source de dopant (24) au réceptacle local de gaz source de dopant (82) seulement lorsque le système d'implantation d'ions est dans un état non opérationnel et le conteneur à gaz (22) n'est pas à ladite tension opérationnelle élevée ;
dans lequel le réceptacle local de gaz source de dopant (82) comprend un réceptacle de distribution et de stockage de gaz contenant un adsorbant physique ayant de l'affinité de sorption pour le gaz source de dopant ; et
dans lequel la conduite d'alimentation (36, 68) est adaptée pour être évacuée lorsque le système d'implantation d'ions (10) est dans un état opérationnel, par un ensemble comprenant une unité centrale de traitement (34) aménagée pour contrôler le débit de gaz à travers ladite conduite d'alimentation (36, 68).

2. Dispositif d'alimentation en gaz source de dopant selon la revendication 1, dans lequel ladite unité centrale de traitement (34) est couplée de façon opérationnelle avec au moins une soupape contrôlant le débit de gaz à travers ladite conduite d'alimentation (36, 68), dans lequel ladite au moins une soupape comprend (i) au moins une soupape (38) dans ladite conduite d'alimentation, ou (ii) une soupape de control de débit dans une tête de soupape (84) dudit réceptacle d'alimentation en gaz source de dopant (24).

3. Dispositif d'alimentation en gaz source de dopant selon l'une quelconque des revendications 1 et 2, dans lequel la conduite d'alimentation (36, 68) comprend une caractéristique choisie parmi les caractéristiques suivantes :
(i) la conduite d'alimentation est construite en matière isolante ;
(ii) la conduite d'alimentation est construite en polytétrafluoroéthylène ;
(iii) la conduite d'alimentation comprend un seul conduit ;
(iv) la conduite d'alimentation comprend un conduit coaxial double.

4. Dispositif d'alimentation en gaz source de dopant selon l'une quelconque des revendications 1 à 3, comprenant en outre un assemblage de purge de gaz (48, 50, 52) pour purger ladite conduite d'alimentation de gaz source de dopant.

5. Dispositif d'alimentation en gaz source de dopant selon l'une quelconque des revendications 1 à 4, dans lequel le réceptacle d'alimentation (24) comprend un réceptacle de distribution et stockage de gaz à pression régulée.

6. Dispositif d'alimentation en gaz source de dopant selon la revendication 1, dans lequel la conduite d'alimentation est munie de multiples passages.

7. Système d'implantation d'ions comportant le dispositif d'alimentation en gaz source de dopant selon l'une quelconque des revendications 1 à 6.

8. Système d'implantation d'ions selon la revendication 7, adapté pour mettre en oeuvre un procédé de fabrication d'un article produit choisi parmi le groupe composé d'articles produits semi-conducteurs, d'articles produits d'écran d'affichage plat, et des articles produits d'énergie solaire.

9. Procédé d'implantation d'ions, comprenant l'utilisation du dispositif d'alimentation en gaz source de dopant selon l'une quelconque des revendications 1 à 6.

10. Procédé selon la revendication 9, dans lequel l'utilisation du dispositif d'alimentation en gaz source de dopant comprend faire fonctionner le système d'implantation d'ions (10) comportant le conteneur à gaz (22), ledit procédé comprenant la disposition du réceptacle local de gaz source de dopant (82) dans le conteneur à gaz (22), l'accouplement du réceptacle local de gaz source de dopant (82) avec le réceptacle d'alimentation en gaz source de dopant (24) positionné éloigné du conteneur à gaz (22) par la conduite d'alimentation (36, 68), et faire circuler du gaz source de dopant du réceptacle d'alimentation (24) au réceptacle local (82) seulement lorsque le système d'implantation d'ions (10) est dans un état non opérationnel et le conteneur à gaz (22) n'est pas à ladite tension opérationnelle élevée.
